# EUROPEAN PATENT APPLICATION

(11) **EP 4 333 080 A1**
(43) Date of publication of application: **06.03.2024**
(21) Application number: 22794813.0
(22) Date of filing: 24.04.2022
(51) Int. Cl.: H01L 31/0216

(54) **CONTACT STRUCTURE APPLIED TO TUNNELING TYPE SOLAR CELL, SOLAR CELL HAVING CONTACT STRUCTURE AND MANUFACTURING METHOD THEREFOR**

(30) Priority: 30.04.2021 CN 202110486549
(71) Applicant: Jolywood (Taizhou) Solar Technology Co., Ltd., Taizhou, Jiangsu 225500 (CN)
(72) Inventor: SHEN, Chenghuan, Taizhou, Jiangsu 225500 (CN); CHEN, Jia, Taizhou, Jiangsu 225500 (CN); JI, Genhua, Taizhou, Jiangsu 225500 (CN); ZHAO, Yingwen, Taizhou, Jiangsu 225500 (CN); DU, Zheren, Taizhou, Jiangsu 225500 (CN); LIN, Jianwei, Taizhou, Jiangsu 225500 (CN)
(74) Representative: Yang, Shu
(86) International application number: PCT/CN2022/088763
(87) International publication number: WO 2022/228342

(57) **Abstract**

The present invention relates to a contact structure applied to a tunneling type solar cell. The tunneling type solar cell comprises a silicon substrate, a dielectric layer and electrodes. One surface of the dielectric layer is in contact with the silicon substrate, and the contact structure is arranged on the other surface of the dielectric layer. The contact structure comprises polycrystalline silicon layers and doped layers. The doped layers and the polycrystalline silicon layers are alternately arranged on the dielectric layer. The thickness of each doped layer is greater than that of each polycrystalline layer. One side of each doped layer is in contact with the dielectric layer, while the other side thereof is in contact with the electrodes. Wherein, the doping concentration of one side of each doped layer in contact with the dielectric layer is less than that of the other side of the doped layer in contact with the electrodes.

## Description

### TECHNICAL FIELD

The present invention relates to the field of solar cells, and in particular to a contact structure applied to a tunneling type solar cell, a solar cell having the contact structure, and a manufacturing method thereof.

### BACKGROUND TECHNIQUE

With the exhaustion of fossil fuels and the pollution caused by the combustion of fossil fuels, people have been looking for a renewable energy source that can replace fossil fuels. Among these renewable energy sources, solar cells are particularly concerned. Among them, silicon wafer type solar cells are the mainstream technology at present. As a semiconductor, silicon contains multiple electron-hole pairs. When light is incident on a solar cell, the electron-hole pairs in silicon will be separated due to the photovoltaic effect. The separated electrons will move to the n-type region, while the separated holes will move to the p-type region. The metal electrodes are electrically connected to the n-type region and the p-type region respectively to collect the separated electrons and holes, thereby obtaining electric energy.

However, the solar cells have a main problem of low photoelectric conversion rate, resulting in low power generation efficiency. One reason is that the ions in the metal will recombine with the electrons in the silicon on the surface of the silicon wafer where the metal electrodes are in contact with the n-type region and the p-type region. Thus, the contact resistance is high, which limits the power generation efficiency of solar cells.

### SUMMARY OF THE PRESENT INVENTION

An objective of the present invention is to provide a solar cell with higher power generation efficiency in order to overcome the defects in the prior art.

A contact structure applied to a tunneling type solar cell is provided, the tunneling type solar cell comprises a silicon substrate, a dielectric layer and electrodes; one surface of the dielectric layer is in contact with the silicon substrate, characterized in that, the contact structure is arranged on the other surface of the dielectric layer; the contact structure comprises polycrystalline silicon layers and doped layers; the doped layers and the polycrystalline silicon layers are alternately arranged on the dielectric layer; the thickness of each doped layer is greater than that of each polycrystalline silicon layer; one side of each doped layer is in contact with the dielectric layer, while the other side thereof is in contact with the electrodes; wherein, the doping concentration of one side of each doped layer in contact with the dielectric layer is less than that of the other side of the doped layer in contact with the electrodes; and, the total area of the projections of the doped layers on the dielectric layer accounts for 2.5% to 97% of the bottom surface area of the dielectric layer.

The contact structure in the present invention also has the following auxiliary features.

The doping concentration of the side of each doped layer in contact with the electrodes is 1 to 50 times of that of the side of the doped layer in contact with the dielectric layer.

The dielectric layer comprises: silicon oxide, aluminum oxide, chromium oxide or a combination thereof.

The dielectric layer has a thickness of 1 nm to 2 nm, preferably 1 nm to 1.4 nm.

A method for manufacturing a contact structure is provided, comprising the following steps of:
step 1: treating the surface of a silicon wafer to form a silicon substrate;
step 2: manufacturing a dielectric layer on the surface of the silicon substrate;
step 3: manufacturing an amorphous silicon layer on the dielectric layer;
step 4: coating dopant-containing silicon slurry on a local region of the amorphous silicon layer, the total area of the dopant-containing silicon slurry coated on the amorphous silicon layer accounting for 2.5% to 97% of the bottom surface area of the amorphous silicon layer; and
step 5: performing high-temperature annealing on the silicon wafer to form a complete contact structure.

A solar cell is provided, comprising: a silicon substrate, an emitter layer, a passivation film, top electrodes, a dielectric layer, a contact structure and bottom electrodes, wherein the emitter layer is arranged on the top surface of the silicon substrate, the passivation film is arranged on the top surface of the emitter layer, and the top electrodes are arranged on the passivation film and connected to the emitter layer; one surface of the dielectric layer is in contact with the bottom surface of the silicon substrate, and the contact structure is arranged between the other surface of the dielectric layer and the bottom electrodes.

A method for manufacturing a solar cell is provided, comprising the following steps of:
step 1: treating the surface of a silicon wafer to form a silicon substrate;
step 2: doping the top surface of the silicon substrate to form an emitter;
step 3: manufacturing a dielectric layer on the bottom surface of the silicon substrate;
step 4: manufacturing an amorphous silicon layer on the dielectric layer;
step 5: coating dopant-containing silicon slurry on a local region of the amorphous silicon layer, the total area of the dopant-containing silicon slurry coated on the amorphous silicon layer accounting for 2.5% to 97% of the bottom surface area of the amorphous silicon layer;
step 6: performing high-temperature annealing on the silicon wafer to form a complete contact structure;
step 7: passivating the top surface and bottom surface of the silicon wafer to form a passivation film; and
step 8: manufacturing metal electrodes on the top surface and bottom surface of the silicon wafer to form a complete solar cell.

A solar cell is provided, comprising a silicon substrate, a passivation layer, a dielectric layer, a contact structure and electrodes, wherein the passivation layer is arranged on the top surface of the silicon substrate, and the dielectric layer is arranged on the bottom surface of the silicon substrate; one surface of the dielectric layer is in contact with the silicon substrate, and the contact structure is arranged between the other surface of the dielectric layer and the bottom electrodes.

The contact structure comprises doped layers and polycrystalline silicon layers which are alternately arranged; and, the doped layers located laterally between each polycrystalline silicon layer have different doping polarity.

A method for manufacturing a solar cell is provided, comprising the following steps of:
step 1: treating the surface of a silicon wafer to form a silicon substrate;
step 2: forming a front field region on the top surface of the silicon wafer;
step 3: manufacturing a dielectric layer on the bottom surface of the silicon wafer;
step 4: manufacturing an amorphous silicon layer on the dielectric layer;
step 5: coating dopant-containing silicon slurry on a local region of the amorphous silicon layer, the total area of the dopant-containing silicon slurry coated on the amorphous silicon layer accounting for 2.5% to 97% of the bottom surface area of the amorphous silicon layer;
step 6: performing high-temperature annealing on the silicon wafer to form a complete contact structure;
step 7: passivating the top surface and bottom surface of the silicon wafer to form a passivation film; and
step 8: manufacturing metal electrodes on the bottom surface of the silicon wafer to form a complete solar cell.

Compared with the existing solar cells, the contact structure in the present invention has the following advantages: Firstly, the doped layers are formed between the electrodes and the dielectric layer, and the doping concentration of the side of each doped layer in contact with the electrodes is greater than that of the side of the doped layer in contact with the dielectric layer. In this way, the doped layers reduce the contamination on the silicon wafer itself from the metal electrodes. Also, the contact resistance is reduced. Secondly, the sides of the doped layers with a lower doping concentration and the polycrystalline silicon layers play a role in passivation and tunneling, thereby improving the power generation efficiency of the solar cell. In addition, the contact structure in the present invention can be applied to various tunneling type batteries, and therefore has a wide range application. The manufacturing process can be realized by only adding 1 to 2 steps to the manufacturing process in the prior art. Moreover, this step does not involve relatively complicated masking and doping processes, and can be completely realized by the existing manufacturing instruments.

### BRIEF DESCRIPTION OF THE DRAWINGS

FIG. 1 is a schematic diagram of the contact structure;
FIG. 2 is the first step in manufacturing the contact structure;
FIG. 3 is the second step in manufacturing the contact structure;
FIG. 4 is the third step in manufacturing the contact structure;
FIG. 5 is the fourth step in manufacturing the contact structure;
FIG. 6 is the fifth step in manufacturing the contact structure;
FIG. 7 is a schematic structure diagram of a first solar cell with the contact structure;
FIG. 8 is the first step in manufacturing the first solar cell with the contact structure;
FIG. 9 is the second step in manufacturing the first solar cell with the contact structure;
FIG. 10 is the third step in manufacturing the first solar cell with the contact structure;
FIG. 11 is the fourth step in manufacturing the first solar cell with the contact structure;
FIG. 12 is the fifth step in manufacturing the first solar cell with the contact structure;
FIG. 13 is the sixth step in manufacturing the first solar cell with the contact structure;
FIG. 14 is the seventh step in manufacturing the first solar cell with the contact structure;
FIG. 15 is the eighth step in manufacturing the first solar cell with the contact structure;
FIG. 16 is a schematic structure diagram of a second solar cell with the contact structure;
FIG. 17 is the first step in manufacturing the second solar cell with the contact structure;
FIG. 18 is the second step in manufacturing the second solar cell with the contact structure;
FIG. 19 is the third step in manufacturing the second solar cell with the contact structure;
FIG. 20 is the fourth step in manufacturing the second solar cell with the contact structure;
FIG. 21 is the fifth step in manufacturing the second solar cell with the contact structure;
FIG. 22 is the sixth step in manufacturing the second solar cell with the contact structure;
FIG. 23 is the seventh step in manufacturing the second solar cell with the contact structure; and
FIG. 24 is the eighth step in manufacturing the second solar cell with the contact structure;
in which: 1: substrate; 2: dielectric layer; 3: electrode; 4: polycrystalline silicon layer; 5: doped layer; 6: amorphous silicon layer; 7: silicon slurry; 8: emitter layer; 9: passivation film; and, 10: front field region.

### DETAILED DESCRIPTION OF THE PRESENT INVENTION

The present invention will be described below in detail by embodiments with references to the accompanying drawings. It is to be pointed out that the embodiments to be described are merely for understanding the present invention and not intended to limit the present invention.

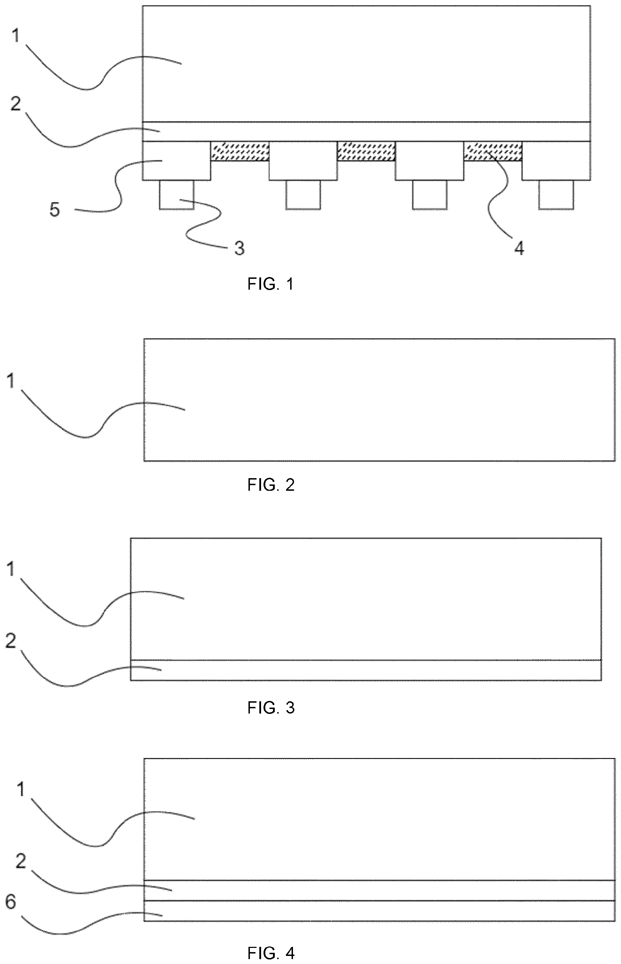

FIG. 1 shows a back structure of a tunneling type solar cell. The solar cell comprises a silicon substrate 1, a dielectric layer 2 arranged on the surface of the silicon substrate 1, and electrodes 3 for outputting current. Wherein, the contact structure of the present invention is arranged between the dielectric layer 2 and the electrodes 3, the contact structure comprises polycrystalline silicon layers 4 and doped layers 5. Wherein, the doped layers 5 and the polycrystalline silicon layers 4 are alternately arranged on the dielectric layer 2. The electrodes 3 are arranged on the doped layers 5, so that one side of each doped layer 5 is in contact with the dielectric layer 2 while the other side thereof is in contact with the electrodes 3. The doping concentration of the side of each doped layer 5 in contact with the electrodes 3 is not less than that of the side of the doped layer 5 in contact with the dielectric layer 2. Wherein, the doping concentration of the side of each doped layer 5 in contact with the electrodes 3 is 1 to 50 times of that of the side of the doped layer 5 in contact with the dielectric layer 2.

In addition, according to the type of the solar cell using the contact structure, the polycrystalline silicon layers 4 may also be doped. The doping type, concentration or other data of the polycrystalline silicon layers 4 will be described in the following embodiments of the specific solar cell. However, no matter what kind of solar cell structure to which the contact structure is applied, the doping concentration of the polycrystalline silicon layers 4 should be less than that of the doped layers 5. The thickness of each doped layer 5 should be greater than that of each polycrystalline silicon layer 4. In addition, the contact structure requires the polycrystalline silicon layers 4 and the doped layers 5 on the dielectric layer 2, in order to achieve the highest power generation efficiency, the total area of the projections of the doped layers 5 on the dielectric layer 2 accounts for 2.5% to 97% of the bottom surface area of the dielectric layer 2. 4% is preferred in this embodiment.

In the contact structure, the dielectric layer 2 has a thickness of 1 nm to 2 nm, preferably 1 nm to 1.4 nm. The materials of the dielectric layer 2 comprise silicon oxide, aluminum oxide, chromium oxide or a combination thereof. The structures of the dielectric layer 2, the polycrystalline silicon layers 4 and the doped layers 5 play a role in interface passivation and tunneling for the solar cell. Also, the light reflection can be reduced, the light utilization rate of the solar cell can be improved, and the power generation efficiency of the solar cell can be increased. Moreover, since the electrodes 3 are only in contact with the doped layers 5, the doped layers 5 reduce the contamination on the silicon substrate 1 and the dielectric layer 2 from the electrodes 3. In addition, since the doping concentration of the side of each doped layer 5 in contact with the electrodes 3 is higher, the contact resistance between the doped layer 5 and the electrode 3 is very low, and the electrons generated by the solar cell can be smoothly outputted by the electrodes 3. Thus, the power generation efficiency of the solar cell is indirectly improved.

Figs. 2-6 show the specific steps of manufacturing the contact structure. Wherein:
With reference to FIG. 2, the upper and lower surfaces of a silicon wafer are treated to form a silicon substrate 1 suitable for manufacturing a solar cell. The pretreatment of the silicon wafer is a conventional means in the art and will not be repeated here.

With reference to FIG. 3, in step 2, the dielectric layer 2 is manufactured on the bottom surface of the silicon substrate 1. The dielectric layer 2 may be made of silicon oxide, aluminum oxide, chromium oxide or a combination thereof.

With reference to FIG. 4, in step 3, an amorphous silicon layer 6 is deposited on the dielectric layer 2. The methods of depositing the amorphous silicon layer 6 include: physical vapor deposition, low pressure chemical vapor deposition, plasma chemical vapor deposition, etc.

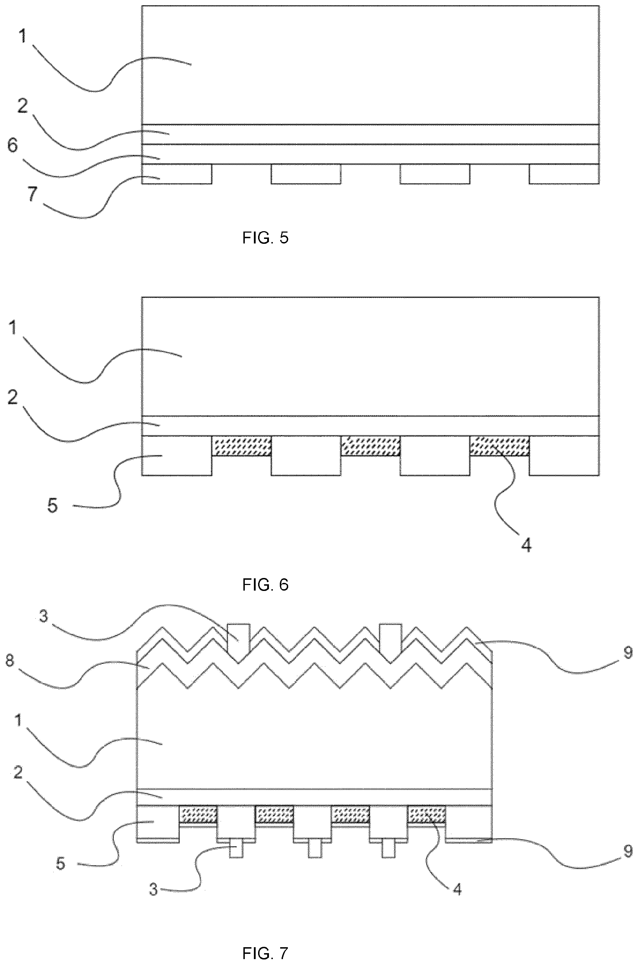

With reference to FIG. 5, in step 4, local doping is performed on the amorphous silicon layer 6, and the total area of the dopant-containing silicon slurry coated on the amorphous silicon layer 6 accounts for 2.5% to 97% of the bottom surface area of the amorphous silicon layer 6, preferably 4% in this embodiment. The doping methods include diffusion, spin-coating, ink jetting, etc. Preferably, the dopant-containing silicon slurry 7 is coated on the amorphous silicon layer 6 by silk-screen printing. The dopant is selected according to the polarity to be doped. For example, if N-type doping is required, a material containing N-type doping ions such as phosphorus is selected. If P-type doping is required, a material containing P-type doping ions such as boron is selected.

With reference to FIG. 6, in step 5, after locally doping on the amorphous silicon layer 6, the silicon wafer is subject to high temperature annealing. Wherein it includes: the silicon wafer is dried for 5 to 20 minutes at a high temperature of 100°C to 400°C. After being dried, the silicon wafer is thermally treated at temperature of 700°C to 1000°C. The thermal treatment time is 10 to 30 minutes. After high-temperature treatment, the amorphous silicon layer 6 will be transformed into the polycrystalline silicon layers 4 and the doped layers 5 at a high temperature. Wherein, the region that is locally doped will form the doped layers 5, while the region that is not locally doped will form the polycrystalline silicon layers 4. Thus, the complete contact structure is formed.

The contact structure can be widely applied to various solar cells, and the first solar cell using the contact structure will be described below with reference to FIG. 7. This cell adopts a tunneling oxide layer passivation contact structure. The electrodes 3 are arranged on the top surface and bottom surface of the cell, respectively. An emitter layer 8, a passivation film 9 and top electrodes 3 are arranged on the top surface of the silicon substrate 1, respectively. The dielectric layer 2, the contact structure and bottom electrodes 3 are arranged on the bottom surface of the silicon substrate 1, respectively. Wherein, the contact structure comprises the polycrystalline silicon layers 4 and the doped layers 5. The doped layers 5 are arranged between the dielectric layer 2 and the bottom electrodes 3. The doping concentration of the side of each doped layer 5 in contact with the bottom electrodes 3 is not less than that of the side of the doped layer 5 in contact with the dielectric layer 2.

In this embodiment, the silicon substrate 1 is an N-type substrate, so that the emitter layer 8 is a P+ emitter layer, and the doped layers 5 are N+ type doped layers. If the silicon substrate 1 is a P-type substrate, the doping polarities of the emitter layer 8 and the doped layers 5 need to be adjusted accordingly. In the solar cell structure, holes and electrons are outputted from the top electrodes and the bottom electrodes, respectively. Thus, preferably, the polycrystalline silicon layers 4 may also adopt a doped structure to reduce the parasitic absorption of carriers. The doping polarity of the polycrystalline silicon layers 4 is the same as the polarity of the doped layers 5, but the doping concentration of the polycrystalline silicon layers 4 is less than that of the doped layers 5.

As described above, the dielectric layer 2, the polycrystalline silicon layers 4 and the doped layers 5 together play a role of passivation and tunneling. The high doping concentration of the sides of the doped layers 5 in contact with the bottom electrodes 3 reduces the contact resistance, and also prevents the electrodes 3 from contaminating the cell. Thus, the power generation efficiency of the whole solar cell is improved.

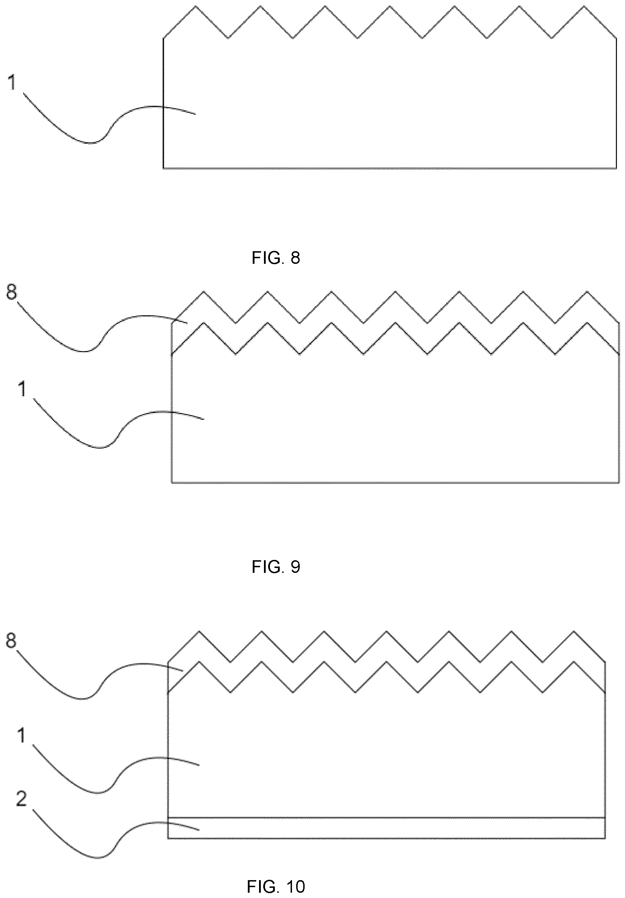

Next, Figs. 8-15 show a method for manufacturing the first solar cell with the contact structure. Electrodes 3 are arranged on the top and bottom of the solar cell. This method comprises the following steps:
With reference to FIG. 8, in step 1, the surface of a silicon wafer is pretreated to form a silicon substrate 1. In this embodiment, the silicon substrate 1 is an N-type silicon substrate. A serrated structure is formed on its top surface to increase the optical path of the solar cell.

With reference to FIG. 9, in step 2, the top surface of the silicon substrate 1 is doped to form an emitter. In this embodiment, the silicon substrate 1 is an N-type substrate. Thus its top surface is P-type doped. The doping element may be boron, and the doping method includes diffusion, spin-coating, ink jetting, silk-screen printing, etc.

With reference to FIG. 10, in step 3, the dielectric layer 2 is manufactured on the bottom surface of the silicon substrate 1. The dielectric layer 2 has a thickness of 1 nm to 2 nm, preferably 1 nm to 1.4 nm, and is made of silicon oxide, aluminum oxide, chromium oxide or a combination thereof.

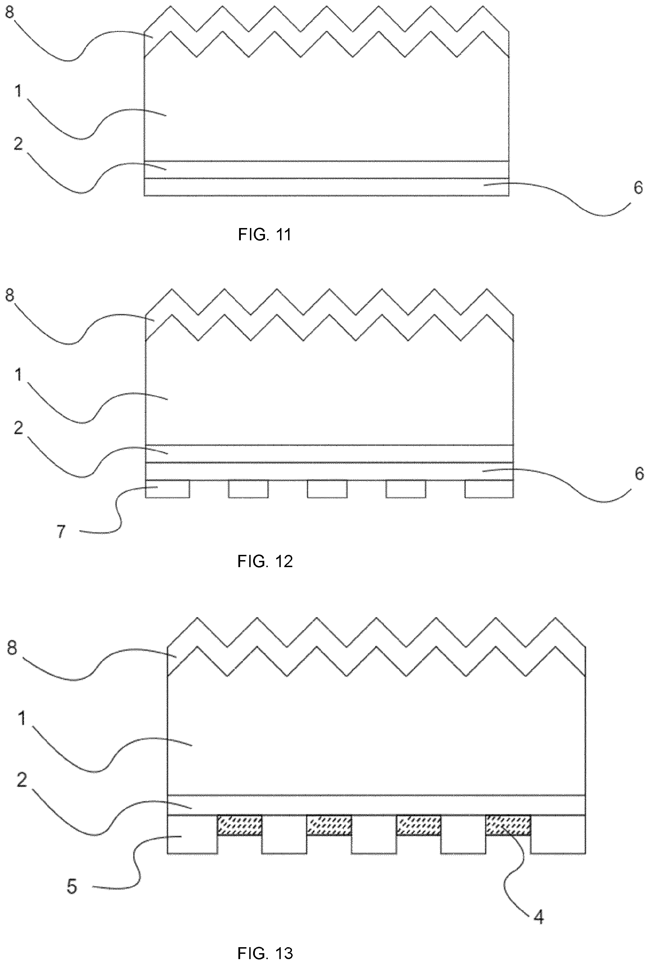

With reference to FIG. 11, in step 4, an amorphous silicon layer 6 is deposited on the dielectric layer 2. The method of depositing the amorphous silicon layer 6 includes: physical vapor deposition, low pressure chemical vapor deposition, plasma chemical vapor deposition, etc.

With reference to FIG. 12, in step 5, local doping is performed on the amorphous silicon layer 6, and the total area of the dopant-containing silicon slurry coated on the amorphous silicon layer 6 accounts for 2.5% to 97% of the bottom surface area of the amorphous silicon layer 6; preferably 4% in this embodiment. The doping method includes diffusion, spin-coating, ink-jet, etc. Preferably, the dopant-containing silicon slurry 7 is coated on the amorphous silicon layer 6 by silk-screen printing. The dopant is selected according to the polarity to be doped. For example, if N-type doping is required, a material containing N-type doping ions such as phosphorus is selected. If P-type doping is required, a material containing P-type doping ions such as boron is selected.

When the solar cell is a TOPCon cell, in order to better improve the cell efficiency, before implementing step 5, the entire surface of the amorphous silicon layer 6 may be doped first and then local doping can be performed. The doping source for the entire surface doping is the same as that for the local doping. With reference to FIG. 13, in step 6, after local doping on the amorphous silicon layer 6, the silicon wafer is subject to high temperature annealing. Wherein it includes: The silicon wafer is dried for 5 to 20 minutes at a high temperature of 100°C to 400°C. After being dried, the silicon wafer is thermally treated at a temperature of 700°C to 1000°C. The thermal treatment time is 10 to 30 minutes. After high-temperature treatment, the amorphous silicon layer 6 will be transformed into the polycrystalline silicon layers 4 and the doped layers 5 at a high temperature. Wherein, the region that is locally doped will form the doped layers 5, while the region that is not locally doped will form the polycrystalline silicon layers 4. Thus, the complete contact structure is formed.

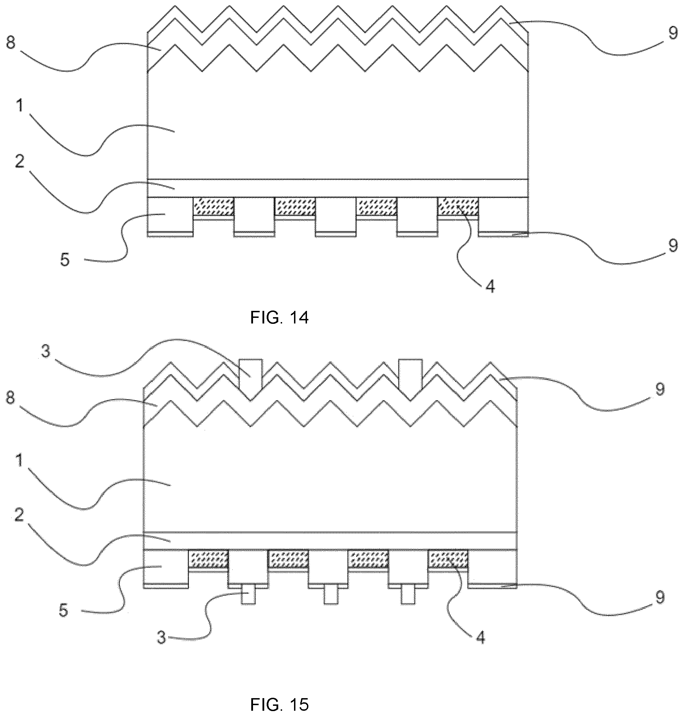

With reference to FIG. 14, in step 7, the top surface and bottom surface of the silicon wafer are cleaned, and the top surface and bottom surface of the silicon wafer are passivated to form a passivation film 9. The passivation treatment includes atomic layer deposition, chemical vapor deposition, atmospheric pressure chemical vapor deposition, etc.

With reference to FIG. 15, in step 8, electrodes 3 are arranged on the emitter layer 8 on the top surface of the silicon wafer and the doped layers 5 on the bottom surface of the silicon wafer, respectively. Thus, the complete solar cell structure is formed.

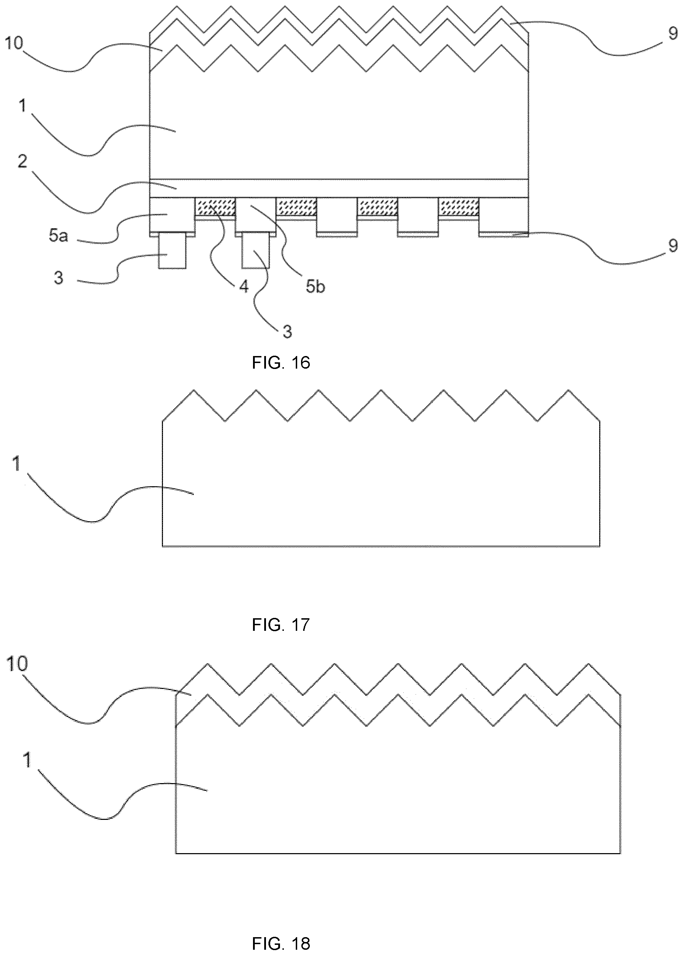

FIG. 16 shows a second solar cell with the contact structure. This cell is a back-junction back contact structure. The pn junctions are located on the back surface of the solar cell. Thus, all electrodes 3 are arranged on the back surface of the cell. The cell comprises a silicon substrate 1, a front field region 10 formed on the top surface of the silicon substrate 1, and a passivation film 9 arranged on the top of the front field region 10. The dielectric layer 2 is arranged on the bottom surface of the silicon substrate 1, and the contact structure is arranged on the dielectric layer 2, it includes polycrystalline silicon layers 4 and doped layers 5 arranged on the dielectric layer 2. The passivation film 9 is also arranged on the bottom surfaces of the polycrystalline silicon layers 4 and the doped layers 5, and the doped layers 5 are connected to the electrodes 3.

In this embodiment, since the PN junctions are all arranged on the bottom surface of the cell, the doped layers 5 and the polycrystalline silicon layers 4 are arranged on the dielectric layer 2 at intervals. Two spaced doped layers 5a and 5b have different doping polarities. For example, the doped layer 5a is N-type doped, and the doped layer 5b is P-type doped. A polycrystalline silicon layer 4 is spaced between the doped layers 5a and 5b. The polycrystalline silicon layer 4 is a non-doped layer, so that the doped layers 5a and 5b can be electrically isolated and the risk of electric leakage can be reduced.

As described above, the dielectric layer 2 plays a role of passivation and tunneling, and its materials include: silicon oxide, aluminum oxide, chromium oxide or a combination thereof. The dielectric layer 2 has a thickness of 1 nm to 2 nm, preferably 1 nm to 1.4 nm. The doping concentration of the sides of the doped layers 5a, 5b in contact with the dielectric layer 2 is not greater than that of the sides of the doped layers 5a, 5b in contact with the electrodes 3. Its concentration ratio is: The doping concentration of the side in contact with the electrodes is 1 to 50 times of that of the side in contact with the dielectric layer. Thus, the contact resistance between the electrodes 3 and the doped layers 5 is reduced, and the efficiency of the solar cell is improved. In addition, in order to achieve the highest power generation efficiency, the total area of the projections of the doped layers 5 on the dielectric layer 2 accounts for 2.5% to 97% of the bottom surface area of the dielectric layer 2. 4% is preferred in this embodiment.

Figs. 17-23 show a method for manufacturing the second solar cell with the contact structure. The method comprises the following steps.

With reference to FIG. 17, in step 1, the surface of a silicon wafer is pretreated to form a silicon substrate 1. In this embodiment, the silicon substrate 1 is an N-type silicon substrate. A serrated structure is formed on its top surface to increase the optical path in the solar cell.

With reference to FIG. 18, in step 2, a front field region 10 is manufactured on the top surface of the silicon substrate 1. Since the silicon substrate 1 in this embodiment is an N-type substrate, its front field region 10 is an N+ type front field region. A mask is manufactured on the front field region 10.

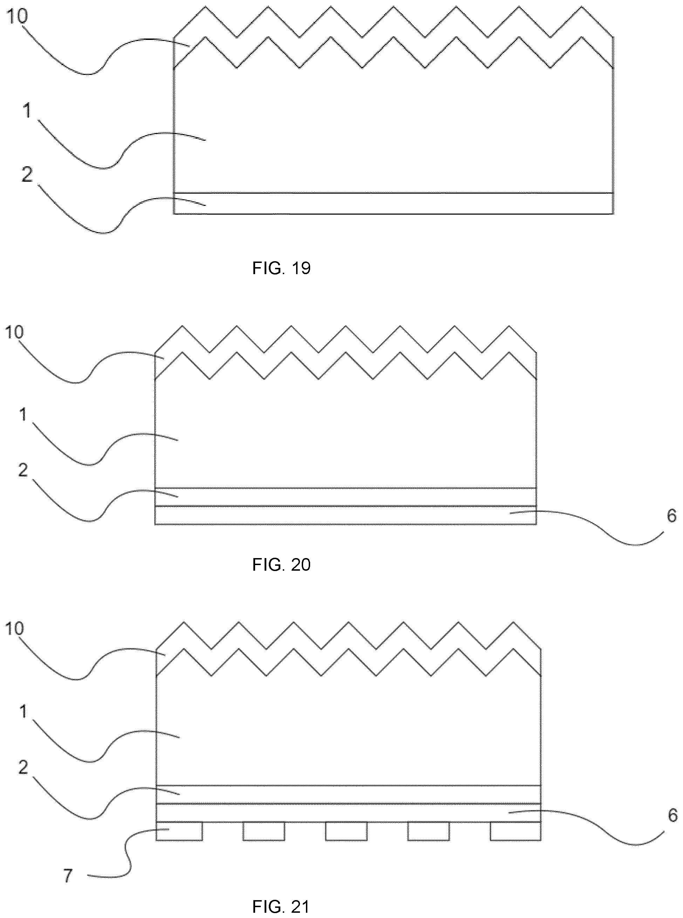

With reference to FIG. 19, in step 3, the dielectric layer 2 is manufactured on the bottom surface of the silicon substrate 1. The dielectric layer 2 has a thickness of 1 nm to 2 nm, preferably 1 nm to 1.4 nm, and its materials include: silicon oxide, aluminum oxide, chromium oxide or a combination thereof. The method of manufacturing the dielectric layer 2 includes: oxidation with nitric acid, high-temperature thermal oxidation, oxidation with ozone, etc.

With reference to FIG. 20, in step 4, an amorphous silicon layer 6 is deposited on the dielectric layer 2. The method of depositing the amorphous silicon layer 6 includes: physical vapor deposition, low pressure chemical vapor deposition, plasma chemical vapor deposition, etc.

With reference to FIG. 21, in step 5, local doping is performed on the amorphous silicon layer 6, and the total area of the dopant-containing silicon slurry coated on the amorphous silicon layer 6 accounts for 2.5% to 97% of the bottom surface area of the amorphous silicon layer 6, preferably 4% in this embodiment. The doping method includes: diffusion, spin-coating, ink jetting, etc. Preferably, the dopant-containing silicon slurry 7 is coated on the amorphous silicon layer 6 by silk-screen printing. The dopant is selected according to the polarity to be doped. For example, if the doped layer 5a is an N-type doped layer, a material containing N-type doping ions such as phosphorus is selected. If the doped layer 5b is a P-type doped layer, a material containing P-type doping ions such as boron is selected.

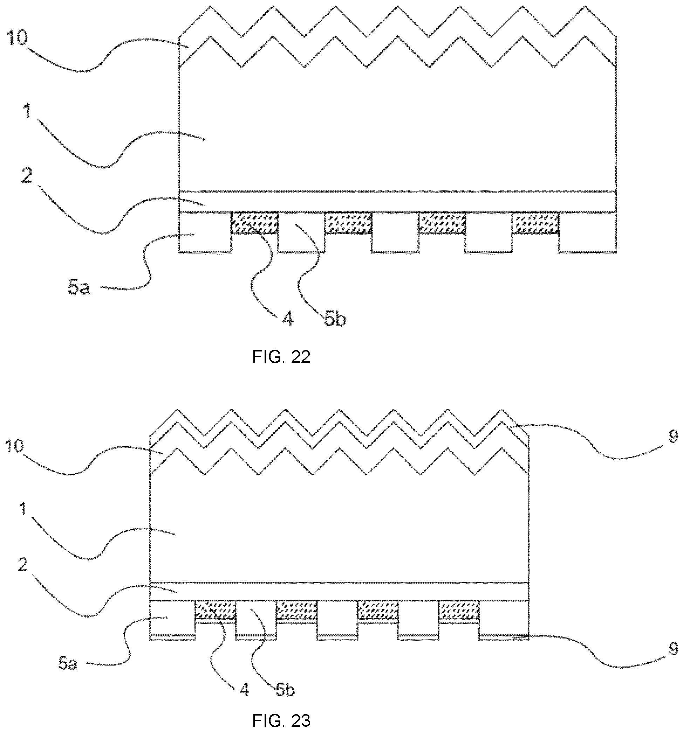

With reference to FIG. 22, in step 6, wherein it includes: the silicon wafer is dried for 5 to 20 minutes at a high temperature of 100°C to 400°C. After being dried, the silicon wafer is thermally treated at a temperature of 700°C to 1000 °C. The thermal treatment time is 10 to 30 minutes. After high-temperature treatment, the amorphous silicon layer 6 will be transformed into the polycrystalline silicon layers 4 and the doped layers 5a and 5b at a high temperature. Wherein, the region that is locally doped will form the doped layers 5a and 5b, while the region that is not locally doped will form the polycrystalline silicon layers 4. Thus, the complete contact structure is formed.

With reference to FIG. 23, in step 7, the top surface and bottom surface of the silicon wafer are cleaned, and the top surface and bottom surface of the silicon wafer are passivated to form a passivation film 9. The passivation treatment includes: atomic layer deposition, chemical vapor deposition, atmospheric pressure chemical vapor deposition, etc.

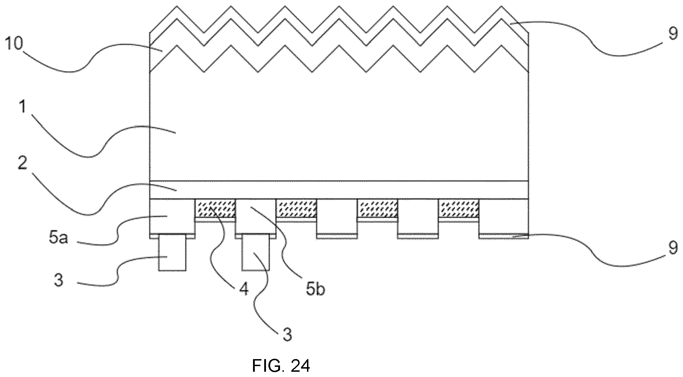

With reference to FIG. 24, in step 8, metal electrodes 3 are arranged on the doped layers 5a and 5b, respectively. Thus, the complete solar cell is formed.

From the perspective of the efficiency of the solar cell, the contact structure plays a role of passivation and tunneling by providing polycrystalline silicon layers 4 and doped layers 5. The doped layers 5, particularly the heavily doped regions in the doped layers 5 connected to the electrodes 3, prevent the metal electrodes 3 from contaminating the silicon wafer and reduce the contact resistance of the solar cell. Thus, the power generation efficiency of the solar cell is improved. From the perspective of the production process of the solar cell, the contact structure is suitable for solar cells of various structures. In the manufacturing process, the contact structure can be obtained by printing a layer of dopant-containing silicon slurry on the amorphous silicon layer and then annealing. It is unnecessary to reform the existing productions lines on a large scale. Moreover, the thickness of the polycrystalline silicon layers 4 is small, and the amount of raw materials required for manufacturing is reduced. Thus, the power generation efficiency of the solar cell is improved, and the production cost of the solar cell is also saved.

Finally, it is to be noted that the forgoing embodiments are merely for describing the technical solutions of the present invention, and not intended to limit the protection scope of the present invention. Although the present invention has been described above in detail by the preferred embodiments, it should be understood by a person of ordinary skill in the art that modifications or equivalent replacements may be made to the technical solutions of the present invention without departing from the essence and scope of the technical solutions of the present invention.

## Claims

1. A contact structure applied to a tunneling type solar cell, the tunneling type solar cell comprises: a silicon substrate (1), a dielectric layer (2) and electrodes (3); one surface of the dielectric layer (2) is in contact with the silicon substrate (1), **characterized in that**, the contact structure is arranged on the other surface of the dielectric layer (2); the contact structure comprises: polycrystalline silicon layers (4) and doped layers (5); the doped layers (5) and the polycrystalline silicon layers (4) are alternately arranged on the dielectric layer (2); the thickness of each doped layer (5) is greater than that of each polycrystalline silicon layer (4); one side of each doped layer (5) is in contact with the dielectric layer (2), while the other side thereof is in contact with the electrodes (3); wherein, the doping concentration of one side of each doped layer (5) in contact with the dielectric layer (2) is less than that of the other side of the doped layer (5) in contact with the electrodes (3); and, the total area of the projections of the doped layers (5) on the dielectric layer (2) accounts for 2.5% to 97% of the bottom surface area of the dielectric layer (2).

2. The contact structure according to claim 1, wherein the doping concentration of the side of each doped layer (5) in contact with the electrodes (3) is 1 to 50 times of that of the side of the doped layer (5) in contact with the dielectric layer (2).

3. The contact structure according to claim 1, wherein the dielectric layer (2) comprises: silicon oxide, aluminum oxide, chromium oxide or a combination thereof.

4. The contact structure according to claim 3, wherein the dielectric layer (2) has a thickness of 1 nm to 2 nm.

5. A method for manufacturing a contact structure, wherein comprising the following steps of:
step 1: treating the surface of a silicon wafer to form a silicon substrate (1);
step 2: manufacturing a dielectric layer (2) on the surface of the silicon substrate (1);
step 3: manufacturing an amorphous silicon layer (6) on the dielectric layer (2);
step 4: coating dopant-containing silicon slurry (7) on a local region of the amorphous silicon layer (6);
the total area of the dopant-containing silicon slurry (7) coated on the amorphous silicon layer (6) accounting for 2.5% to 97% of the bottom surface area of the amorphous silicon layer (6); and
step 5: performing high-temperature annealing on the silicon wafer to form a complete contact structure.

6. A solar cell, comprising: a silicon substrate (1), an emitter layer (8), a passivation film (9), top electrodes (3), a dielectric layer (2), a contact structure and bottom electrodes (3), wherein the emitter layer (8) is arranged on the top surface of the silicon substrate (1), the passivation film (9) is arranged on the top surface of the emitter layer (8), and the top electrodes (3) are arranged on the passivation film (9) and connected to the emitter layer (8); one surface of the dielectric layer (2) is in contact with the bottom surface of the silicon substrate (1), and the contact structure is arranged between the other surface of the dielectric layer (2) and the bottom electrodes (3); wherein, the contact structure is the contact structure according to any one of claims 1 to 5.

7. A method for manufacturing the solar cell according to claim 6, wherein comprising the following steps of:
step 1: treating the surface of a silicon wafer to form a silicon substrate (1);
step 2: doping the top surface of the silicon substrate (1) to form an em itter;
step 3: manufacturing a dielectric layer (2) on the bottom surface of the silicon substrate (1);
step 4: manufacturing an amorphous silicon layer (6) on the dielectric layer (2);
step 5: coating dopant-containing silicon slurry (7) on a local region of the amorphous silicon layer (6);
the total area of the dopant-containing silicon slurry (7) coated on the amorphous silicon layer (6) accounting for 2.5% to 97% of the bottom surface area of the amorphous silicon layer (6);
step 6: performing high-temperature annealing on the silicon wafer to form a complete contact structure;
step 7: passivating the top surface and bottom surface of the silicon wafer to form a passivation film (9); and
step 8: manufacturing metal electrodes (3) on the top surface and bottom surface of the silicon wafer to form a complete solar cell.

8. A solar cell, comprising a silicon substrate (1), a passivation layer, a dielectric layer (2), a contact structure and electrodes (3), the passivation layer is arranged on the top surface of the silicon substrate (1), and the dielectric layer (2) is arranged on the bottom surface of the silicon substrate (1); one surface of the dielectric layer (2) is in contact with the silicon substrate (1), and the contact structure is arranged between the other surface of the dielectric layer (2) and the bottom electrodes (3); wherein, the contact structure is the contact structure according to any one of claims 1 to 5.

9. The solar cell according to claim 8, wherein the contact structure comprises doped layers (5) and polycrystalline silicon layers (4) which are alternately arranged; and, the doped layers (5) located laterally between each polycrystalline silicon layer (4) have different doping polarity.

10. A method for manufacturing the solar cell according to claim 8 or 9, wherein, comprising the following steps of:
step 1: treating the surface of a silicon wafer to form a silicon substrate (1);
step 2: forming a front field region (10) on the top surface of the silicon wafer;
step 3: manufacturing a dielectric layer (2) on the bottom surface of the silicon wafer;
step 4: manufacturing an amorphous silicon layer (6) on the dielectric layer (2);
step 4: coating dopant-containing silicon slurry (7) on a local region of the amorphous silicon layer (6);
the total area of the dopant-containing silicon slurry (7) coated on the amorphous silicon layer (6) accounting for 2.5% to 97% of the bottom surface area of the amorphous silicon layer (6);
step 6: performing a high-temperature annealing on the silicon wafer to form a complete contact structure;
step 7: passivating the top surface and bottom surface of the silicon wafer to form a passivation film (9); and
step 8: manufacturing metal electrodes (3) on the bottom surface of the silicon wafer to form a complete solar cell.
